Europäisches Patentamt

European Patent Office

Office européen des brevets

(19)

(11) Veröffentlichungsnummer: **0 181 439**

**A2**

(12) # EUROPÄISCHE PATENTANMELDUNG

(21) Anmeldenummer: 85109957.2

(22) Anmeldetag: 07.08.85

(51) Int. Cl.⁴: **H 03 G 3/00**
**H 03 L 7/08**

(30) Priorität: 10.11.84 DE 3441143

(43) Veröffentlichungstag der Anmeldung:
21.05.86 Patentblatt 86/21

(84) Benannte Vertragsstaaten:
AT CH LI NL

(71) Anmelder: ANT Nachrichtentechnik GmbH
Gerberstrasse 33
D-7150 Backnang(DE)

(72) Erfinder: Ruthemann, Klaus, Dipl.-Ing.
Rietenauer Weg 22
D-7150 Backnang(DE)

(74) Vertreter: Schickle, Gerhard, Dipl.-Ing.
AEG-TELEFUNKEN Nachrichtentechnik GmbH K1 E7
Gerberstrasse 33
D-7150 Backnang(DE)

(54) Schaltung zur Voreinstellung einer Regelspannung.

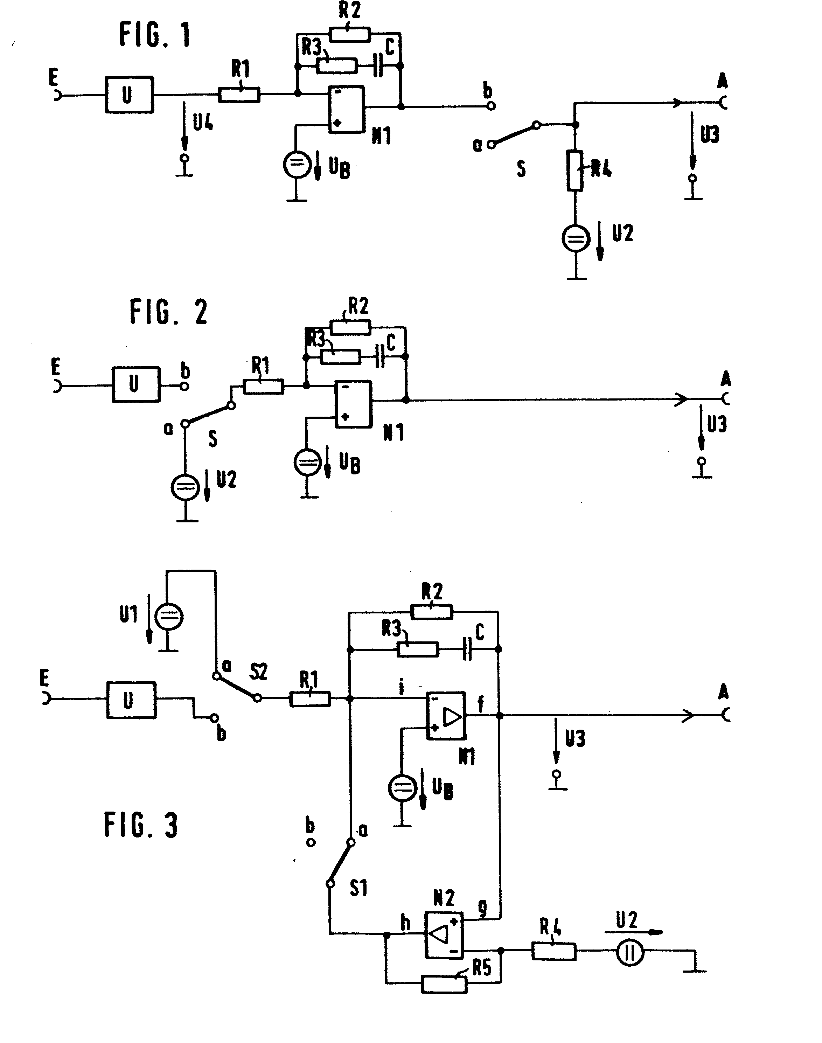

(57) Die Schaltung bewirkt, daß in einem Regelkreis der Regelvorgang abgeschaltet wird und dabei die Ausgangsspannung des Regelverstärkers auf einen festgelegten Wert einstellbar ist (Fig. 3).

FIG. 3

EP 0 181 439 A2

## Schaltung zur Voreinstellung einer Regelspannung

Die Erfindung betrifft eine Anordnung zur Voreinstellung eines Verstärkers, wie er beispielsweise als Regler in einem Phasenregelkreis Verwendung findet.

Für bestimmte Anwendungsfälle besteht in solchen Systemen die Notwendigkeit, die vom spannungsgesteuerten Oszillator (VCO) erzeugte Frequenz auf einen vorgegebenen Wert fest einzustellen. Dies kann beispielsweise der Fall sein, wenn bei Ausfall der Eingangssignalspannung die Regelgröße (Phase) im Kreis nicht mehr definiert ist, oder aus anderen Gründen eine Abschaltung der Regelung erwünscht ist.

Schaltungen zur Gewinnung solcher Abschaltkriterien sind bekannt; in den Figuren 1, 2 und 3 sind deshalb auch nur die davon betätigten Stellglieder in Form von Schaltern dargestellt. Dabei entspricht jeweils die Schalterstellung "a" dem Abschaltzustand und die Schalterstellung "b" dem normalen Betriebszustand des Regelkreises.

Der Schalter S1 und - sofern vorhanden S2 - wird durch ein von außen einwirkendes Schaltkriterium betätigt, welches beispielsweise eine Pegelüberwachung der Eingangssignalspannung E sein kann. Eine unmittelbare Reaktion der Schalter auf Ausfälle der dargestellten Bauelemente ist weder von der erfindungsgemäßen Anordnung, noch von den beiden dargestellten intern bekannten Lösungen beabsichtigt.

Es versteht sich, daß die erfindungsgemäße Ausführung nicht an die Verwendung von mechanischen Kontakten gebunden ist, vielmehr lassen sich in der Praxis vorteilhaft elektronische Schalter wie z.B. Feldeffekttransistoren einsetzen, oder auch die in manchen linearen Verstärkern mögliche Hochohmigsteuerung des Ausgangs.

Der Erfindung liegt die Aufgabe zugrunde, eine Schaltung der eingangs genannten Art anzugeben, bei welcher im Abschaltzustand einerseits die voreingestellte Regelspannung U3 möglichst genau eingehalten wird, und andererseits die am Regelverstärker N1 sowie am Kondensator C anliegenden Gleichspannungen dabei den Werten des Betriebsfalles nahekommen.

Die Aufgabe wird durch die im Patentanspruch aufgeführten Merkmale gelöst. Zur besseren Erläuterung des Erfindungsgegenstandes seien zunächst zwei intern bekannte Lösungen beschrieben.

Figur 1 zeigt eine Möglichkeit, bei der in Reihe zum Ausgang des Regelverstärkers N1 ein Schalter S angebracht ist, hinter dem eine Spannung U2 über einen Innenwiderstand R4 die Größe der Steuerspannung U3 bestimmt, sofern der Schalter S geöffnet ist. Bei geschlossenem Schalter S bleibt die Spannung U2 wegen des niederohmigen Ausgangs des Regelverstärkers N1 ohne Wirkung. Im Falle einer Abschaltung des Regelkreises (Schalterstellung a) wird gewöhnlich die in Fig. 2 bezeichnete Spannung U4 merkbar von ihrem vorherigen Wert abweichen. In Verbindung mit der meist hohen Gleichstromverstärkung des Regelverstärkers N1 ($R2 \gg R1$) bedeutet dies, daß die Ausgangsspannung von N1 maximal negativ bzw. positiv wird. Die dabei entstehende Aufladung des Kondensators C wirkt sich nachteilig aus, wenn anschließend in die normale Betriebsweise zurückgeschaltet wird. Ist U4 beispielsweise die Ausgangsspannung des Phasendetektors in einem Phasenregelkreis, so führt die notwendige Umladung im Kondensator C zu einem länger andauernden Phasenfehler. Gegebenenfalls wird auch das Einrasten der Regelschleife verzögert und es findet ein sogenannter Ziehvorgang statt.

Figur 2 zeigt eine weitere Möglichkeit, bei welcher der Eingang des Regelverstärkers N1 zwischen der Ausgangsspannung des Umsetzers U und einer Hilfsspannung U2 umgeschaltet wird. Bei dieser Anordnung wirkt sich die im allgemeinen hohe Gleichspannungsverstärkung des beschalteten
Regelverstärkers N1 nachteilig aus, da die Spannung U3 in
stärkerem Maße abhängig wird von Schwankungen der Spannung
U2 sowie der am Regelverstärker N1 anliegenden Bezugsspannung $U_B$.

Die erfindungsgemäße Lösung nach Figur 3 hingegen vermeidet
diesen Nachteil, indem sie bei Abschaltung des Regelkreises
die Ausgangsspannung des Regelverstärkers N1 über einen
zweiten linearen Regelverstärker N2 nachstellt. Sie geht
dabei von der Erwägung aus, daß die dargestellte Steuerspannung U3 für beide Betriebsweisen der Anordnung eine
ähnliche Größe besitzt. Auf diese Weise wird sich auch die
Ladung des Kondensators C nur vergleichsweise wenig ändern,
sodaß die oben angeführten Schwierigkeiten beim Einrastvorgang stark vermindert werden. Am Eingang E der Schaltung
liegt die Regelgröße an. Die Steuerspannung für die Stellgröße wird am Ausgang A abgegriffen. Der am Eingang angeordnete Umsetzer U liefert eine Ausgangsspannung proportional zur Regelgröße. Der Ausgang f des ersten Regelverstärkers N1 ist mit dem einen Eingang g des zweiten
Regelverstärkers N2 verbunden. Dessen Ausgang h ist über
einen Schalter S1 mit einem Eingang i des ersten Regelverstärkers N2 verbunden. Die Summe der Betriebsphasen
in dieser Schleifenschaltung geht für niedriger werdende
Frequenzen gegen einen Grenzwert von -180°. Die hohe
Summe der Schleifenverstärkungen der Verstärker N1 und
N2 garantieren zudem eine große Genauigkeit der Stellspannung U3.

Zur Unterstützung der Schaltungsfunktion empfiehlt es
sich, in praktischen Anwendungen einen weiteren Schalter
S2 und eine Hilfsspannung U1 vorzusehen, wenn die Ausgangsspannung des Umsetzers U in der Betriebsart "Abschal-

4

tung" nicht konstant ist. Dabei ist die Größe dieser Hilfsspannung U1 weitgehend unkritisch.

Die erfindungsgemäße Schaltung zeigt ein gutes dynamisches
Verhalten bei Umschaltungen zwischen Abschalt- und Betriebszustand.

- - - - -

5

ANT Nachrichtentechnik GmbH
Gerberstraße 33
D-7150  Backnang


Patentanspruch:


Anordnung zur Voreinstellung der Ausgangsspannung eines
Verstärkers, dadurch gekennzeichnet, daß der Ausgang (f)
eines ersten linearen Regelverstärkers (N1) verbunden
ist mit einem Eingang (g) eines zweiten linearen Regelverstärkers (N2), dessen Ausgang (h) über einen Schalter
(S1) mit einem Eingang (i) des ersten Verstärkers (N1)
verbunden ist.

0181439

# FIG. 1

# FIG. 2

# FIG. 3